Europäisches Patentamt

European Patent Office

Office européen des brevets

(19)

(11) Numéro de publication: **0 234 640 B1**

(12) FASCICULE DE BREVET EUROPEEN

(45) Date de publication de fascicule du brevet:
21.11.91

(51) Int. Cl.⁵: **H03M 3/04, G06F 15/353**

(21) Numéro de dépôt: 87200209.2

(22) Date de dépôt: 11.02.87

(54) Circuit de décodage d'échantillons numériques en MICD.

(30) Priorité: 14.02.86 FR 8602026

(43) Date de publication de la demande:
02.09.87 Bulletin 87/36

(45) Mention de la délivrance du brevet:
21.11.91 Bulletin 91/47

(84) Etats contractants désignés:
DE FR GB

(56) Documents cités:
FR-A- 2 150 843
FR-A- 2 386 941
GB-A- 2 078 406
US-A- 3 598 908

PHILIPS RESEARCH REPORTS SUPPLEMENT,
no. 8, 1974, pages 25-32, Eindhoven, NL;
"Differentielle pulscode-modulation
(DPCM)"

ALTA FREQUENZA, vol. 53, no. 2, mars-avril
1984, pages 77-83, Milano, IT; S.C. BROFFE-
RIO: "An integrated differential pulse code
modulator based on PLA's for digital television applications"

(73) Titulaire: **LABORATOIRES D'ELECTRONIQUE
PHILIPS
3, Avenue Descartes
F-94450 Limeil-Brévannes(FR)**
(84) Etats contractants désignés:
**FR**

Titulaire: **N.V. Philips' Gloeilampenfabrieken
Groenewoudseweg 1
NL-5621 BA Eindhoven(NL)**
(84) Etats contractants désignés:
**DE GB**

(72) Inventeur: **Auger, Robert
Société Civile S.P.I.D. 209, rue de l'Université
F-75007 Paris(FR)**

(74) Mandataire: **Landousy, Christian et al
Société Civile S.P.I.D. 156, Boulevard Haussmann
F-75008 Paris(FR)**

Description

L'invention concerne un circuit de décodage d'échantillons numériques définissant N points d'un signal initial selon une différence absolue da, codée sur p bits, entre deux échantillons consécutifs du signal initial transmis par un émetteur, en modulation d'impulsions codées différentielle MICD, selon des échantillons numériques transcodés sur r bits avec r inférieur à p, à une cadence déterminée par une horloge H1.

Ce circuit de décodage trouve son application dans les étages de réception effectuant le traitement de données numériques stockées dans des mémoires de masse ou transmises par voies hertziennes.

Une invention de ce genre est connue du livre "Digital processing of speech signals" de L.R. RABINER, R.W. SCHAFER, Prentice-Hall Inc Englewood Cliffs, NEW-JERSEY, pages 208 et suivantes. Le codage par modulation d'impulsions codées différentielle MICD (DPCM en langue anglaise) est une technique de codage numérique dans laquelle les différences des valeurs entre deux échantillons adjacents codés numériquement sont utilisées pour le stockage ou la transmission. Le codage MICD peut aussi être considéré comme un codage à prédiction dans lequel on utilise la différence entre une valeur présente et une prédiction. Les variations entre deux données numériques successives, codées sur q bits, sont déterminées puis représentées par des valeurs transmises sous la forme d'échantillons numériques, codés sur p bits avec p inférieur à q afin de réduire le débit numérique nécessaire à la transmission.

Le circuit de réception opère la transformation inverse, c'est-à-dire qu'il ajoute successivement la valeur représentée par les échantillons numériques da reçus à la valeur précédemment déterminée. Ces échantillons da sont codés de sorte qu'à la réception le circuit de décodage va présenter un organe de transcodage suivi d'un additionneur dont la sortie est bouclée sur une de ses entrées, l'ensemble opérant à la même cadence que celle définie à l'émission.

Le récepteur doit ainsi effectuer d'abord la reconstitution du signal puis son filtrage pour le rendre exploitable. Ceci entraîne une certaine complexité et nécessite un grand nombre de fonctions logiques notamment pour le filtrage. Le nombre de couches logiques que chaque opération met en oeuvre conduit à une certaine limitation de la vitesse d'exécution du circuit de décodage.

Ainsi le signal initial, qui est défini à l'émission par N points, est également obtenu sur N points à la réception après décodage. Généralement ce signal est ensuite lissé par filtrage pour éliminer les irrégularités de restitution. Pour le traitement de signaux numériques. il a été proposé d'accroître la cadence de restitution des échantillons de sortie en générant des échantillons supplémentaires. Ceci est par exemple réalisé dans le document GB 2 078 406, mais avec des signaux différents tels que des signaux MIC. Ce document décrit un interpolateur linéaire basé sur une structure de filtre récursif et sur un circuit diviseur par N, la sortie de l'interpolateur opérant à une cadence N fois supérieure à celle de l'entrée. Mais le circuit décrit ne concerne nullement les signaux MICD.

Les applications qui exploitent le codage MICD mettent à profit le fait que ce type de codage permet, sans trop dégrader le signal reconstruit, de réduire considérablement le débit numérique à transmettre, ce qui est très important dans le cas des mémoires de masse ou des liaisons hertziennes.

Le but de l'invention est ainsi d'adapter l'interpolation linéaire au traitement des signaux MICD, en combinant entre elles les opérations de transcodage et de filtrage. Il est également d'assurer une plus grande vitesse d'exécution en réduisant le nombre de couches logiques mises en oeuvre pour la restitution du signal de réception.

Un autre but de l'invention, en diminuant le nombre de couches et donc de fonctions logiques, est de réduire la surface de cristal nécessaire pour la réalisation d'un circuit intégré constituant le circuit de décodage.

Pour cela l'invention telle que définie dans le préambule est remarquable en ce que le circuit de décodage comprend des moyens de décodage MICD qui effectuent, à partir des échantillons numériques transcodés reçus suivant l'horloge H1 de période T1, dans un unique dispositif de transcodage et d'interpolation, la combinaison d'un transcodage et d'une interpolation linéaire obtenue en effectuant un transcodage inverse et en générant des échantillons numériques obtenus en divisant la différence absolue da par un nombre n, afin de fournir des échantillons numériques transcodés et divisés dad = da/n, qui arrivent sur une entrée d'un additionneur opérant au sein d'une boucle d'accumulation, à une cadence plus élevée que celle du transcodage, déterminée par une horloge H2 de période T2, telle que T2 = T1/n, avec n entier supérieur à 1, afin de restituer M points du signal MICD décodé avec M supérieur à N, les points supplémentaires étant obtenus par interpolation linéaire.

Il est connu que pour obtenir une restitution correcte d'un signal il est nécessaire de l'échantillonner à une cadence qui présente une limite inférieure liée aux fréquences maximales à transmettre, c'est-à-dire à la bande passante du signal. Pour cette fréquence d'échantillonnage minimale, le nombre minimal d'échantillons permet théoriquement de reconstituer le signal initial. Le signal ainsi reconstruit est ensuite filtré. L'invention se propose de réaliser l'opération de filtrage en effectuant une interpolation linéaire entre deux échantillons numériques reçus consécutivement, opérée au cours de l'opération de décodage MICD proprement dite, qui a pour objet d'ajouter continûment une valeur incrémentale. Selon l'invention cette valeur incrémentale est déterminée par le taux d'interpolation utilisé. Ce taux détermine le rapport des périodes T1 et T2 des horloges H1 de l'émission et H2 de l'étage final du circuit de décodage. Ce rapport est tel que T2 = T1/n avec n supérieur à 1. Les valeurs incrémentales transmises par l'émetteur étant da, les valeurs incrémentales ajoutées continûment, pendant chaque période T2, vont être égales à dad = da/n. La boucle va ainsi, pour chaque période T1, ajouter n fois la valeur da/n puis pour la période T1 suivante va ajouter n fois une autre valeur da/n, selon le mécanisme :

```
- séquence (i-1) de durée T1
  X(i-1, 0) + dad(i-1) = X(i-1, 1)
  X(i-1, 1) + dad(i-1) = X(i-1, 2)
  ..............................
  X(i-1, n) + dad(i-1) = X(i, 0)
- séquence i de durée T1
  X(i, 0) + dad(i) = X(i, 1)
  ..............................
  X(i, n) + dad(i) = X(i+1, 0).
```

Afin de pouvoir effectuer successivement toutes ces opérations il est nécessaire de stocker temporairement les échantillons numériques dans des bascules.

L'invention possède donc des moyens de décodage MICD qui comprennent :
- une bascule B1 qui stocke, sous le contrôle de l'horloge H1, les échantillons MICD reçus et les transmet au dispositif de transcodage et d'interpolation qui délivre des échantillons transcodés et divisés à une bascule B2 contrôlée par une horloge H3, de période T1, retardée par rapport à H1,
- un additionneur, qui reçoit sur une première entrée les données de la bascule B2, et fournit son résultat à une bascule B3, contrôlée par l'horloge H2, qui transmet ses données sur la seconde entrée de l'additionneur selon un montage en boucle, la sortie de l'additionneur étant également reliée à une bascule B4, contrôlée par une horloge H4, de période T2, retardée par rapport à H2, qui délivre le signal MICD décodé.

Les échantillons numériques da sont codés sur p bits puis transcodés sur r bits pour être émis vers le circuit de décodage avec r inférieur à p. Le dispositif de transcodage et d'interpolation selon l'invention génère des échantillons d'amplitude dad = da/n qui doivent être codés sur un nombre plus élevé que p bits pour assurer une précision suffisante aux opérations. Ce nombre de bits est égal à (p + s), c'est-à-dire que s bits sont ajoutés avec s défini comme étant la première puissance de 2 qui vérifie l'inégalité n inférieur ou égal à $2^s$.

L'invention sera mieux comprise à l'aide des figures suivantes, données à titre d'exemples non limitatifs, qui représentent :

figure 1 :    une illustration du mécanisme de décodage et d'interpolation selon l'invention,
figure 2 :    un schéma-bloc du circuit de décodage selon l'invention,
figure 3 :    un diagramme des temps pour un circuit de décodage avec n = 2,
figure 4 :    un schéma d'un dispositif de fondu enchaîné comprenant deux circuits de décodage selon l'invention.

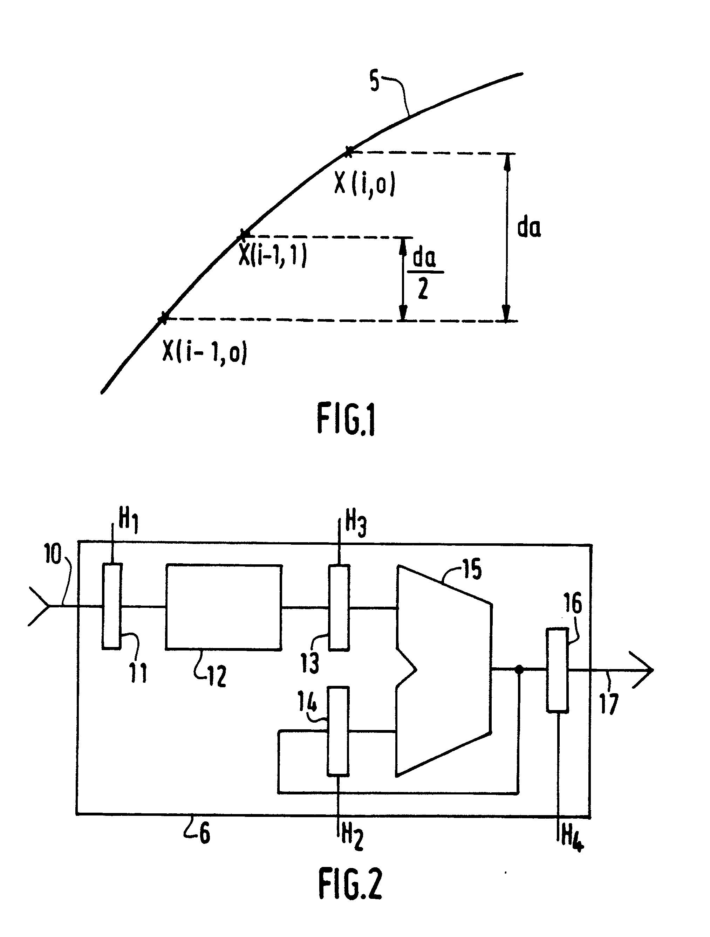

La figure 1 illustre le mécanisme de décodage et d'interpolation mis en oeuvre par l'invention. Soit un signal à restituer représenté par une courbe 5. En utilisant, après décodage, les échantillons numériques da qui se présentent à la sortie du circuit de décodage, on restitue par additions successives les points de la courbe X(i-1, 0), X(i, 0), ... Le circuit de décodage selon l'invention permet de déterminer des points intermédiaires, par exemple un point X(i-1, 1) dans le cas de la figure 1 avec n = 2, ou plus généralement n-1 points intermédiaires X(i-1, n-1).

Le schéma-bloc du circuit de décodage 6 est représenté sur la figure 2. Il comprend une bascule B1 11 qui stocke sous le contrôle de l'horloge H1 les codes des échantillons numériques da transcodés présents sur la connexion 10, codés sur r bits. Ces codes entrent dans un dispositif de transcodage et d'interpolation 12 qui délivre en sortie les échantillons transcodés et divisés de valeur da/n. Ce transcodage et cette interpolation peuvent être effectués par exemple à l'aide d'une mémoire morte dans laquelle les codes des échantillons da transcodés sont utilisés comme adresses pour lire les échantillons da/n préalablement stockés. Il peut également être effectué par une mémoire vive ou un réseau logique programmable. Le transcodage et l'interpolation peuvent par exemple être effectués de la manière suivante :

| valeurs de la différence de signal | code transmis | valeurs reconstituées | valeur dad(n = 2) |
|---|---|---|---|
| 0-2 | 0 | 1 | 0,5 |
| 3-6 | 1 | 4 | 2,0 |
| 7-12 | 2 | 9 | 4,5 |
| 13-21 | 3 | 16 | 8,0 |
| 22-35 | 4 | 27 | 13,5 |
| 36-61 | 5 | 44 | 22 |
| 62-99 | 6 | 79 | 39,5 |
| 100-255 | 7 | 120 | 60 |
| -(1-2) | 8 | -1 | -0,5 |
| -(3-6) | 9 | -4 | -2,0 |
| -(7-12) | 10 | -9 | -4,5 |
| -(13-21) | 11 | -16 | -8,0 |
| -(22-35) | 12 | -27 | -13,5 |
| -(36-61) | 13 | -44 | -22 |
| -(62-99) | 14 | -79 | -39,5 |
| -(100-255) | 15 | -120 | -60 |

Chaque échantillon dad = da/n est conservé dans une bascule B2 13, contrôlée par l'horloge H3, pendant la période T1. La sortie de la bascule B2 13 est reliée à une des entrées d'un additionneur 15 dont la sortie est rebouclée sur sa deuxième entrée à travers une bascule B3 14 contrôlée par l'horloge H2 qui délivre une valeur Si. La sortie de l'additionneur 15 est également réunie à une bascule B4 16 contrôlée par l'horloge H4 qui délivre le résultat final Si + $dad_i$ sur la connexion 17 avec (p + s) bits.

Ainsi les bascules 11 et 13 conservent leurs données stables pendant chaque période T1, tandis que les bascules 14 et 16 conservent les leurs pendant chaque période T2.

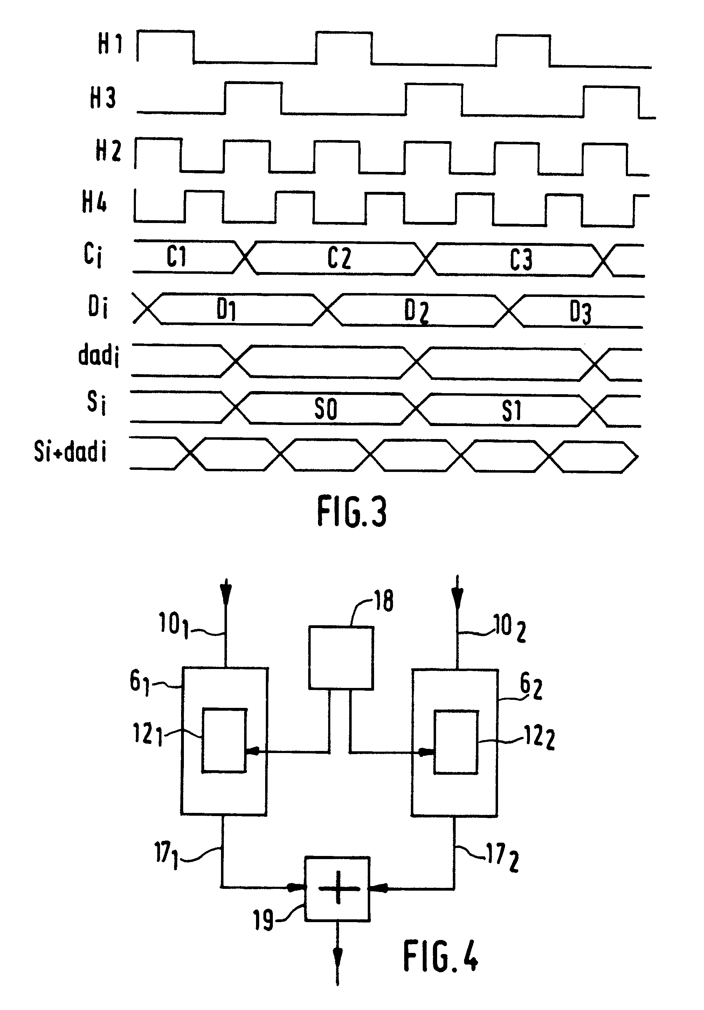

La figure 3 représente le diagramme des temps dans le cas où le taux d'interpolation est égal à 2. L'horloge H2 a donc une période T2 deux fois plus courte que la période T1 de l'horloge H1. Les codes des échantillons numériques reçus Ci sont stockés par exemple sur le front montant de l'horloge H1 selon les échantillons Di. Ceux-ci sont transcodés et stockés selon les échantillons $dad_i$ sur le front montant de H3. Les échantillons Si sont stockés sur le front montant de H2 et le résultat Si $\overline{+ dad_i}$ est délivré sur le front montant de H4.

Le circuit de décodage selon l'invention est utilisé pour traiter les signaux de luminance Y et les signaux de différence de couleurs R-Y et B-Y selon un standard télévision. Pour cela trois circuits de décodage selon l'invention traitent simultanément ces signaux. Ceci est utilisé dans des appareils de visualisation d'images codées numériquement servant par exemple dans des ordinateurs de type domestiques ou autres. Ils peuvent également servir dans tout dispositif de visualisation d'images ou tout dispositif audio mettant en oeuvre le décodage MICD.

La figure 4 représente le schéma d'un dispositif de fondu enchaîné d'images, comprenant deux circuits de décodage selon l'invention.

Les signaux en provenance de deux images différentes, que l'on désire représenter successivement en les enchaînant, arrivent sur les connexions d'entrée $10_1$ et $10_2$ et pénètrent dans les circuits de décodage $6_1$ et $6_2$. Pour réaliser le fondu enchaîné les dispositifs de transcodage $12_1$ et $12_2$ délivrent les valeurs da/n précédentes altérées par des coefficients d'atténuation respectivement k et 1-k. Pendant la durée au cours de laquelle le fondu enchaîné doit s'effectuer, les coefficients k et 1-k sont régulièrement modifiés de 1 à 0 pour l'un et simultanément de 0 à 1 pour l'autre. Ceci est obtenu en utilisant des mémoires vives comme dispositifs de transcodage et d'interpolation $12_1$ et $12_2$ qui sont rechargées régulièrement avec des valeurs modifiées à chaque fois par les coefficients nouveaux k et 1-k par un contrôleur 18.

Selon un autre mode les dispositifs de transcodage et d'interpolation $12_1$ et $12_2$ sont des réseaux logiques programmables qui délivrent les valeurs modifiées choisies par le contrôleur 18.

Selon ces deux modes les données issues des dispositifs $6_1$ et $6_2$ sont additionnées dans un additionneur 19 qui délivre un signal égal à la somme pondérée des signaux $M_1$ et $M_2$ présents sur les

4

deux voies d'entrée $10_1$ et $10_2$ suivant l'équation :

$$s = k \cdot M_1 + (1-k) M_2,$$

le coefficient k variant d'une visualisation d'image à une autre, l'effet obtenu étant un fondu enchaîné.

**Revendications**

1. Circuit de décodage d'échantillons numériques définissant N points d'un signal initial selon une différence absolue da, codée sur p bits, entre deux échantillons consécutifs du signal initial transmis par un émetteur, er modulation d'impulsions codées différentielle MICD, selon des échantillons numériques transcodés sur r bits avec r inférieur à p, à une cadence déterminée par une horloge H1, caractérisé en ce que le circuit comprend des moyens de décodage MICD (6) qui effectuent, à partir des échantillons numériques transcodés reçus suivant l'horloge H1 de période T1, dans un unique dispositif de transcodage et et d'interpolation (12), la combinaison d'un transcodage et d'une interpolation linéaire obtenue en effectuant un transcodage inverse et en générant des échantillons numériques obtenus en divisant la différence absolue da par un nombre n, afin de fournir des échantillons numériques transcodés et divisés dad = da/n, qui arrivent sur une entrée d'un additionneur opérant au sein d'une boucle d'accumulation, à une cadence plus élevée que celle du transcodage, déterminée par une horloge H2 de période T2, telle que T2 = T1/n, avec n entier supérieur à 1, afin de restituer M points du signal MICD décodé avec M supérieur à N, les points supplémentaires étant obtenus par interpolation linéaire.

2. Circuit selon la revendication 1, caractérisé en ce que les moyens de décodage MICD comprennent :
   - une bascule B1 qui stocke, sous le contrôle de l'horloge H1, les échantillons MICD reçus et les transmet au dispositif de transcodage et d'interpolation qui délivre des échantillons transcodés et divisés à une bascule B2 contrôlée par une horloge H3, de période T1, retardée par rapport à H1,
   - un additionneur, qui reçoit sur une première entrée les données de la bascule B2, et fournit son résultat à une bascule B3, contrôlée par l'horloge H2, qui transmet ses données sur la seconde entrée de l'additionneur selon un montage en boucle, la sortie de l'additionneur étant également reliée à une bascule B4, contrôlée par une horloge H4, de période T2, retardée par rapport à H2, qui délivre le signal MICD décodé.

3. Circuit selon la revendication 2, caractérisé en ce que le dispositif de transcodage et d'interpolation fournit pour chaque échantillon numérique codé sur p-bits, des échantillons numériques transcodés et divisés dad = da/n, codés sur (p + s) bits, où s est défini comme étant la première puissance de 2 tel que n est inférieur ou égal à $2^s$.

4. Circuit selon la revendication 3, caractérisé en ce que les échantillons dad sont stockés dans le dispositif de transcodage et d'interpolation qui est une mémoire morte, une mémoire vive ou un réseau logique programmable, adressé par les échantillons transcodés reçus.

5. Utilisation d'au moins un circuit de décodage selon une des revendications 1 à 4 soit dans un dispositif de visualisation d'images, soit dans un dispositif de visualisation d'images au standard télévision pour le décodage des signaux de luminance et/ou de chrominance, soit dans un dispositif de traitement de signaux audio.

6. Utilisation du circuit de décodage selon une des revendications 1 à 4 pour la réalisation d'un dispositif de visualisation d'images à fondu enchaîné comprenant :
   - sur une première voie, au moins un circuit de décodage muni d'un dispositif de transcodage et d'interpolation qui délivre des valeurs qui peuvent être modifiées par un coefficient k,
   - sur une seconde voie, au moins un circuit de décodage muni d'un dispositif de transcodage et d'interpolation qui délivre des valeurs qui peuvent être simultanément modifiées par un coefficient 1-k, les coefficients k et 1-k pouvant être régulièrement modifiés par un contrôleur entre des valeurs 0 à 1 pour l'un et simultanément 1 à 0 pour l'autre,
   - et un additionneur qui additionne les signaux issus de ces deux voies selon un mécanisme de fondu enchaîné.

5

## Claims

1. A decoding circuit for digital samples defining N points of an initial signal transmitted by a transmitter by means of differential pulse code modulation DPCM at a rate determined by a clock H1 and each defining the absolute difference da encoded into p bits between two consecutive samples of the initial signal which digital samples are transcoded into r bits, where r is smaller than p, characterized in that the circuit comprises DPCM decoding means (6) which effect, from transcoded digital samples received in accordance with the clock H1 having a period T1 in a unique interpolation and transcoding arrangement (12), the combination of a transcoding and a linear interpolation obtained by effecting inverse transcoding and by generating digital samples obtained by dividing the absolute difference da by a number n in order to supply transcoded and divided digital samples dad = da/n which are received at an input of an adder operating within an accumulation loop at a rate which is higher than the transcoding rate determined by a clock H2 having a period T2 such as T2 = T1/n, in which n is an even number which is higher than 1 in order to recover M points of the decoded DPCM signal, in which M is higher than N, the supplementary points being obtained by linear interpolation.

2. A circuit as claimed in Claim 1, characterized in that the DPCM decoding means comprise:
   - a latch circuit B1 which stores the received DPCM samples under the control of the clock H1 and transmits them to the transcoding and interpolation arrangement which supplies transcoded and divided samples to a latch circuit B2 controlled by a clock H3 having a period T1 and being delayed with respect to H1,
   - an adder which receives at a first input the data from the latch circuit B2 and supplies its result to a latch circuit B3 controlled by a clock H2 which transmits its data to the second input of the adder in accordance with a loop configuration, the output of the adder being connected to a latch circuit B4 controlled by a clock H4 having a period T2 and being delayed with respect to H2 which supplies the decoded DPCM signal.

3. A circuit as claimed in Claim 2, characterized in that the interpolation and transcoding arrangement provides for each digital sample coded into p bits transcoded and divided digital samples dad = da/n coded into (p + s) bits with s being defined as the first power of 2 so that n is smaller than or equal to $2^s$.

4. A circuit as claimed in Claim 3, characterized in that the samples dad are stored in the interpolation and transcoding arrangement which is a read-only memory, a random access memory or a programmable logic network addressed by received transcoded samples.

5. Use of at least a decoding circuit as claimed in any one of Claims 1 to 4, in a picture display device, or in a standard television picture display device for decoding luminance and/or chrominance signals, or in a device for processing audio signals.

6. Use of the decoding circuit as claimed in any one of Claims 1 to 4 for realising a device for displaying fading images, comprising:
   - in a first path at least a decoding circuit provided with an interpolation and transcoding arrangement which supplies values which may be modified by a coefficient k,
   - in a second path at least a decoding circuit provided with an interpolation and transcoding arrangement which supplies values which may be simultaneously modified by a coefficient 1-k, whilst the coefficients k and 1-k may be regularly modified by a control device between the values 0 and 1 for k and simultaneously between 1 and 0 for 1-k,
   - and an adder which adds the signals supplied from these two paths in accordance with a fading method.

## Patentansprüche

1. Dekodierschaltung für digitale Abtastwerte, die N Punkte eines Ausgangssignals definieren, entsprechend einer in p Bits kodierten, absoluten Differenz da zwischen zwei aufeinander folgenden Abtastwerten des von einem Sender im Differenz-Pulscode-Modulationsverfahren (DPCM) ausgestrahlten Ausgangssignals, entsprechend digitalen in r Bits transkodierten Abtastwerten, mit r kleiner als p, mit einer durch einen Taktgeber H1 bestimmten Frequenz, **dadurch gekennzeichnet,** daß die Schaltungsanord-

## EP 0 234 640 B1

nung Differenz-Pulskode-Modulations-Dekodiermittel (DPCM) (6) aufweist, die, ausgehend von transkodierten, digitalen Abtastwerten, die entsprechend dem Taktgeber H1 mit der Periode T1 erhalten worden sind, in einer als Einheit ausgebildeten Transkodier- und Interpolieranordnung (12) eine kombinierte Transkodierung und lineare Interpolation herbeiführen, die dadurch erhalten worden ist, daß eine lineare Transkodierung durchgeführt und digitale Abtastwerte erzeugt wurden, die dadurch erhalten worden sind, daß die absolute Differenz da durch eine Zahl n geteilt wurde, damit digitale, transkodierte und geteilte Abtastwerte dad = da/n erhalten werden, die bei einem Eingang eines in einer Akkumulationsschleife wirksamen Addierers eintreffen mit einer Frequenz, die höher ist als die der Transkodierung, die durch einen Taktgeber H2 mit der Periode T2 bestimmt ist, so daß T2 = T1/n, n eine ganze Zahl größer als 1, damit M Punkte des dekodierten DPCM-Signals wiederhergestellt werden, M größer als N, wobei die zusätzlichen Punkte durch lineare Interpolation erhalten werden.

2. Schaltungsanordnung nach Anspruch 1, **dadurch gekennzeichnet,** daß die DPCM-Dekodiermittel die folgenden Elemente aufweisen:
   - eine Kippschaltung B1, die unter Ansteuerung des Taktgebers H1 die im DPCM-Verfahren erhaltenen Abtastwerte sowie die der Transkodier- und Interpolationsanordnung zugeführten Abtastwerte speichert, wobei die genannte Transkodier- und Interpolationsanordnung transkodierte und geteilte Abtastwerte zu einer durch einen Taktgeber H3 mit einer Periode T1 gesteuerten und um H1 verzögerten Kippschaltung B2 liefert,
   - einen Addierer, der an einem ersten Eingang die Daten der Kippschaltung B2 erhält und das Ergebnis einer durch den Taktgeber H2 gesteuerten Kippschaltung B3 liefert, die ihre Daten einem zweiten Eingang des als Schleifenschaltung ausgebildeten Addierers zuführt, wobei der Ausgang des Addierers ebenfalls mit einer durch den Taktgeber H4 mit der Periode T2 gesteuerten, gegenüber H2 verzögerten Kippschaltung B4 gekoppelt ist, die ein dekodiertes DPCM-Signal liefert.

3. Schaltungsanordnung nach Anspruch 2, **dadurch gekennzeichnet,** daß die Transkodier- und Interpolationsanordnung für jeden mit p-Bits kodierten Abtastwert digitale transkodierte und geteilte dad = da/n, mit (p + s) Bits kodierte Abtastwerte liefert, wobei s als die erste Potenz von 2 derart bestimmt wird, daß n kleiner als oder gleich $2^s$ ist.

4. Schaltungsanordnung nach Anspruch 3, **dadurch gekennzeichnet,** daß die Abtastwerte dad in der Transkodier- und Interpolationsanordnung gespeichert werden, die ein Festwertspeicher, ein Speicher mit beliebigem Zugriff oder ein programmierbares logisches Netzwerk ist, das durch die erhaltenen transkodierten Abtastwerte adressiert ist.

5. Verwendung wenigstens einer Dekodierschaltung nach einem der Ansprüche 1 bis 4, entweder in einer Bildwiedergabeanordnung, oder in einer Bildwiedergabeanordnung für genormtes Fernsehen zur Dekodierung von Leuchtdichte- und/oder Farbartsignalen, oder aber in einer Audio-Signalverarbeitungsanordnung.

6. Verwendung der Dekodierschaltung nach einem der Ansprüche 1 bis 4 zum Bilden einer Bildwiedergabeanordnung mit weicher Überblendung, welche die folgenden Elemente aufweist:
   - in einer ersten Signalstrecke, mindestens eine Dekodierschaltung mit einer Transkodier- und Interpolationsanordnung, die Werte liefert, die durch einen Koeffizienten k geändert werden können,
   - in einer zweiten Signalstrecke, mindestens eine Dekodierschaltung mit einer Transkodier- und Interpolationsanordnung, die Werte liefert, die alle durch einen Koeffizienten 1-k geändert werden können, wobei die Koeffizienten k und k-1 durch eine Regelschaltung zwischen den Werten 0 und 1 für den einen und gleichzeitig zwischen 1 und 0 für den anderen ordnungsgemäß geändert werden können,
   - und einen Addierer, der die über die beiden Signalstrecken gelieferten Signale entsprechend einem Verfahren mit weicher Überblendung addiert.

FIG.1

FIG.2

FIG.3

FIG.4